Europäisches Patentamt

European Patent Office

Office européen des brevets

(11) Veröffentlichungsnummer: **0 301 319**
**A1**

(12) **EUROPÄISCHE PATENTANMELDUNG**

(21) Anmeldenummer: 88111248.6

(51) Int. Cl.⁴: **H03L 5/00**

(22) Anmeldetag: 13.07.88

(30) Priorität: 17.07.87 DE 3723751

(43) Veröffentlichungstag der Anmeldung:
01.02.89 Patentblatt 89/05

(84) Benannte Vertragsstaaten:
DE FR GB IT NL

(71) Anmelder: **Siemens Aktiengesellschaft Berlin
und München**
**Wittelsbacherplatz 2**
**D-8000 München 2(DE)**

(72) Erfinder: **Fenk, Josef, Dipl.-Ing**
**Deutenhauserstrasse 10**
**D-8057 Eching/Ottenburg(DE)**

(54) **Monolithisch integrierbare, amplitudengeregelte Oszillator-Differenzverstärkerschaltung.**

(57) Amplitudenregelbare Oszillator-Differenzverstärkerschaltung, bei der durch die Minimierung störender parasitärer Kapazitäten die Bandbreite erweitert wird und bei der demzufolge zur Beaufschlagung eines Reglers ein unsymmetrisches Ausgangssignal vorgesehen ist und die Regelung die Ausgangssignalamplitude durch Variation des Differenzversträkerstromes beeinflußt.

FIG 2

## Monolithisch integrierbare, amplitudengeregelte Oszillator-Verstärker-Schaltung

Die Erfindung betrifft eine monolithisch integrierbare, amplitudengeregelte Oszillator-Verstärker-Schaltung nach dem Oberbegriff des Patentanspruches 1.

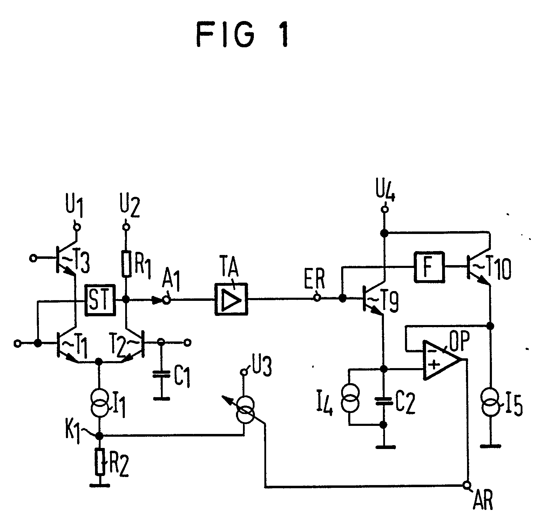

Amplitudengeregelte Oszillator-Verstärker, auch in Form von Differenzverstärkeranordnungen, mit einer Reglerschaltung, bei der die Eingangssignale gleichgerichtet werden, bei der die unerwünschten, nicht zur Regelgröße gehörenden Signalanteile durch die Gleichtaktunterdrückung des Differenzverstärkereinganges einer Operationsverstärkerschaltung eliminiert werden und bei der eine Sollwerteinstellung vorgesehen ist, sind unter anderem aus der DE-PS 30 41 392 bekannt. In Schaltungen nach FIG 1 aus der DE-PS 30 41 392 wird das Ausgangssignal an den Kollektoren der beiden Transistoren des Oszillator-Differenzverstärkerpaares symmetrisch ausgekoppelt und für den Regler zur Istwerterfassung unter Mittelwertbildung der Gleichkomponente und Gleichrichtung des hochfrequenten Anteiles herangezogen.

Bei Variation der Kollektorspannungen des Differenzverstärkerpaares stellt sich jedoch bei solchen Schaltungen zwischen den Kollektorspannungen der beiden Transistoren ein DC-Offset ein, der sich als Regelstörgröße bemerkbar machen kann. Außerdem wird die Bandbreite des Oszillator-Verstärkers durch den am ersten Transistor auftretenden Miller-Effekt und durch weitere parasitäre Kapazitäten negativ beeinflußt. Bei Oszillator-Differenzverstärkern der obengenannten Art ist nämlich im allgemeinen zwischen dem Basisanschluß des ersten Transistors und dem Kollektoranschluß des zweiten Transistors ein frequenzbestimmendes Schaltungsteil angeordnet. In dem durch das frequenzbestimmende Schaltungsteil und das Differenzverstärkerpaar ge bildeten Schwingkreis führen die parasitären Kapazitäten der Transistoren sowie der eventuell an den Basisanschlüssen der Transistoren angeschlossenen Baugruppen zu einer Tiefpaßwirkung. Die Wirkung des Miller-Effektes kann, wie in Tietze/Schenk, Halbleiter-Schaltungstechnik, 5. Aufl. 1980, S. 330-333 erwähnt, durch eine Kaskodeschaltung eliminiert werden. Der Einsatz einer solchen Schaltung ist jedoch bei symmetrischer Signalauskopplung an den Kollektoren der Oszillator-Verstärkertransistoren, wie in der vorgenannten DE-PS 30 41 392 nur in abgewandelter, wenig wirksamer Form möglich. Zwischen den Kollektoranschlüssen der in Emitterschaltung betriebenen Transistoren und den Emitteranschlüssen der in Basisschaltung betriebenen Transistoren sind nämlich in diesem Fall Lastwiderstände erforderlich, die der Eliminierung des Miller-Effektes entgegenstehen. Im Bereich des Transistors, dessen Kollektor mit dem frequenzbestimmenden Schaltungsteil verbunden ist, wird die Verstärkerbandbreite hauptsächlich durch die parasitäre Kollektor-Basis-Kapazität beeinträchtigt, die übrigen an diesem Transistor auftretenden parasitären Kapazitäten führen lediglich zu einer Veränderung der Resonanzfrequenz.

Die parasitäre Kollektor-Basis-Kapazität wird von der Sperrschichtkapazität zwischen Kollektor und Basis gebildet. Je größer die Spannung zwischen Kollektor und Emitter und daraus resultierend die Sperrspannung zwischen Kollektor und Basis ist, desto kleiner ist die Sperrschichtkapazität. Sollte bei vorgegebener Betriebsspannung der Lastwiderstand zwischen Kollektoranschluß und Betriebsspannung einen bestimmten, relativ hohen Wert nicht unterschreiten, so muß also der Emitteranschluß möglichst niederohmig an das Bezugspotential geschaltet werden, um in Abhängigkeit vom Strom eine möglichst hohe Spannung im Transistor und somit eine möglichst geringe parasitäre Kapazität zu erhalten.

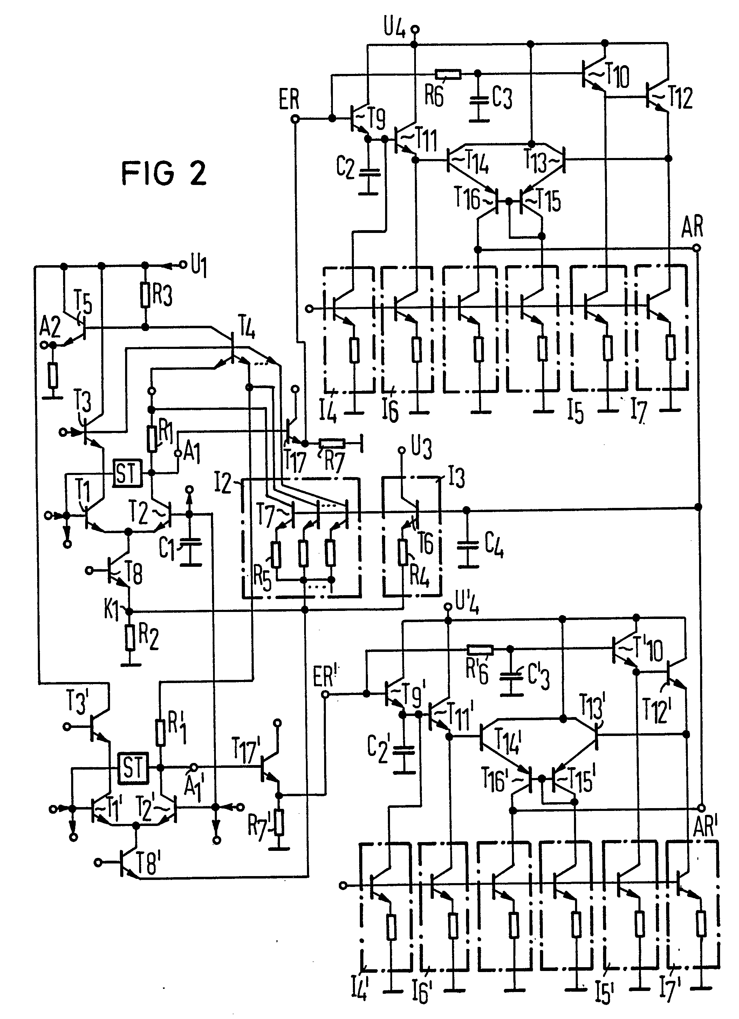

In der vorgenannten DE-PS weist der Regler zwei Eingänge mit je einem Gleichrichter auf, die zur Beaufschlagung mit einem symmetrischen Ausgangssignal eines Differenzverstärkers und zur Vollweggleichrichtung dieses Signales vorgesehen sind. Der Aus gang jedes Gleichrichters ist jeweils mit einem Eingang eines Operationsverstärkers verbunden. Das Ausgangssignal des Operationsverstärkers und somit des Regelsystems ist proportional zu dem Differenzsignal der beiden Eingangssignale. Besteht das an beiden Eingängen anstehende Signal aus einem symmetrisch ausgekoppelten Differenzverstärkerausgangssignal mit einer Gegentakt-Wechselspannungskomponente sowie einem Gleichspannungsanteil und Störgrößen in Form von Gleichtakt-Wechselspannungskomponenten, so werden die Gleichtakt-Komponenten vom Regler unterdrückt und nur der Gegentakt-Anteil des Eingangssignals beeinflußt das Ausgangssignal des Reglers. Der Proportionalitätsfaktor zwischen Eingangsdifferenzsignal und Ausgangssignal und somit der Sollwert des Reglers wird in der Schaltung, die in der DE-PS 30 41 392, insbesondere in Figur 2, dargelegt ist, durch eine Gleichspannungsdifferenz zwischen den beiden Eingängen des Operationsverstärkers festgelegt. Diese Gleichspannungsdifferenz wird durch eine zusätzliche DC-Arbeitspunkteinstellung an mindestens einem Operationsverstärkereingang erzielt, die üblicherweise mehrere Widerstände enthält.

Bei bekannten Oszillator-Differenzverstärkern, wie dem in der PS 30 41 392 DE beschriebenen, wirkt die Reglerausgangsspannung der Amplitudenregelung direkt auf das Potential eines Basisan-schlusses des Differenzverstärkerpaares und ver-ändert in Abhängigkeit von der Oszillator-Ausgangssignalamplitude somit den Arbeitspunkt des Differenzverstärkers. Die kapazitive Ausgangsimpedanz der Reglerschaltung belastet hierbei die Basisanschlüsse der Transistoren und begrenzt somit die Bandbreite der Verstärkerschaltung.

Eine andere Möglichkeit, den Arbeitspunkt des Differenzverstärkers zu ändern, liegt darin, die eingespeißten Emitterströme der Differenzverstärker-Transistoren zu variieren.

Nachteile einer Reglerschaltung nach dem oben beschriebenen Stande der Technik sind der zusätzliche Bauteileaufwand zur Arbeitspunkteinstellung an den Operationsverstärkereingängen des Reglers und die direkte Abhängigkeit des tatsächlichen Sollwertes von der Konstanz der Arbeit-spunktspannung des Oszillatorverstärkers. Außer-dem ist die in der DE-PS 30 41 392 beschriebene Reglerschaltung nur für die Regelung von Differenzverstärkerpaaren mit symmetrischer Istwert-Auskopplung sinnvoll einsetzbar.

Aufgabe der Erfindung ist es, bei einem Oszillator-Differenzverstärker mit geregelter Aus-gangsamplitude die durch parasitäre Schaltungsel-emente bedingte Verringerung der Bandbreite zu minimieren, ohne daß sich die zusätzliche Rauschleistung der Regelschleife am Ausgang des Oszillatorverstärkers störend bemerkbar macht.

Diese Aufgabe wird bei einer geregelten Oszillatorverstärkerschaltung der eingangs genannten Art durch die Merkmale des kennzeichnenden Teiles des Patentanspruches 1 gelöst. Weiterbildungen der Erfindung sind in den Unteransprüchen gekennzeichnet.

FIG 1 stellt ein Prinzipschaltbild der Schaltung nach Patentanspruch 1 dar.

Der in FIG 1 gezeigte Oszillator-Verstärker wird durch eine monolithisch integrierbare Differenzverstärker-Schaltung realisiert, bei der der Kollektor des ersten Transistors $T_1$ unter Bildung einer Kaskodeschaltung unmittelbar mit dem Emit-ter eines dritten Transistors $T_3$ verbunden ist und der Kollektor dieses dritten Transistors $T_3$ an das erste Potential $U_1$ geschaltet ist, bei der der Kollek-tor des zweiten Transistors $T_2$ als ein erster Ver-stärkerausgang $A_1$ vorgesehen ist und über einen ersten Widerstand $R_1$ an ein zweites Potential $U_2$ geschaltet ist und die Emitter des ersten Transi-stors $T_1$ und des zweiten Transistors $T_2$ über eine erste Stromquelle mit dem Bezugspotential (Masse) verbunden sind und bei der als erste Stromquelle die Serienschaltung einer zweiten

Stromquelle $I_1$ und einer mit dieser über einen ersten Schaltungsknoten $K_1$ verbundenen siebten Konstantstromquelle, insbesondere eines zweiten Widerstandes $R_2$, vorgesehen ist, bei der für den Oszillatorverstärker eine Amplitudenregelung in Abhängigkeit vom Ausgangssignal vorgesehen ist, bei der der erste Ausgang $A_1$ des Oszillatorverstärkers über einen Trennverstärker TA an den Signaleingang ER eines Reglers geschaltet ist, bei der der Basisanschluß eines neunten Transistors $T_9$ mit dem Signaleingang ER der Reglerschaltung verbunden ist und der Basisanschluß eines zehnten Transistors $T_{10}$ über einen Tiefpaß F ebenfalls an den Signaleingang ER geschaltet ist, bei der die Kollektoranschlüsse des neunten und des zehnten Transistors jeweils an ein Potential, insbesondere ein gemeinsames fünftes Versorgungspotential $U_4$ angeschlossen sind, bei dem der Emitter des neu-nten Transistors $T_9$ mit einem, insbesondere dem nichtinvertierenden Eingang eines Operationsverstärkers OP verbunden ist und über eine zweite Kapazität $C_2$ sowie über eine erste Konstantstrom-quelle $I_4$ an das Bezugspotential (Masse) geschaltet ist, bei dem der Emitter des zehnten Tran-sistors $T_{10}$ mit dem anderen, insbesondere dem invertierenden Eingang des Operationsverstärkers OP verbunden ist und außerdem über eine zweite Konstantstromquelle $I_5$ an das Bezugspotential (Masse) geschaltet ist, bei dem der Ausgang des Operationsverstärkers mit dem Ausgang AR des Reglers verbunden ist, bei dem das Verhältnis des Stromes der zweiten Konstantstromquelle $I_5$ zu dem Strom der ersten Konstantstromquelle $I_4$ zur Sollwerteinstellung vorgesehen ist, bei dem das Stellglied des Regelkreises aus einer ersten spannungsgesteuerten Stromquelle besteht, bei dem der Steuerspannungseingang dieser ersten spannungsgesteuerten Stromquelle mit einer von einem Regler mit entkoppeltem Eingang ER bereitgestellten Stellgröße beaufschlagt wird und bei der der Stromeingang der ersten spannungsgesteuerten Stromquelle an ein drittes Potential $U_3$ ange-schlossen ist und ihr Stromausgang mit dem ersten Schaltungsknoten $K_1$ verbunden ist (FIG 1). Die zweite Stromquelle $I_1$ kann insbesondere aus ein-em in Basisschaltung betriebenen achten Transistor bestehen, wobei der Emitter dieses Transistors mit dem zweiten Widerstand $R_2$ über den ersten Knoten $K_1$ verbunden ist, dieser erste Knoten $K_1$ mit dem Stromausgang der ersten spannungsgesteuerten Stromquelle zusammengeschaltet ist und der Basisanschluß des achten Transistors an ein konstantes Potential geschaltet ist. Durch das konstante Basispotential des achten Transistors wird in der Basisschaltung ein weitgehend konstantes Potential am Emitteranschluß dieses Transistors eingestellt, so daß der zweite Widerstand, der zwischen diesem Emitteranschluß und dem Bezugspotential angeordnet ist, einen konstanten Strom führt. Wird dem ersten Knoten $K_1$ ein Teil dieses durch den zweiten Widerstand $R_2$ festgelegten Stromes durch die erste spannungsgesteuerte Stromquelle zugeführt, so fließt durch den achten Transistor ein um diesen zugeführten Stromanteil verminderter Strom.

Die zur Einstellung der Arbeitspunkte der Transistoren erforderlichen Gleichpotentiale werden in bekannter Weise, z.B. durch Widerstände, den jeweiligen Transistoren zugeführt.

Eine Verbesserung der Regelkonstanz sowie die Eliminierung des Miller-Effektes, der im Bereich des über die Basis mit dem frequenzbestimmenden Schaltungsteil verbundenen Transistors auftritt, wird erfindungsgemäß dadurch ermöglicht, daß das Signal zur Ermittlung der Eingangsgröße eines Reglers unsymmetrisch an nur einem Kollektor des Oszillator-Differenzverstärkers abgeführt wird. Dadurch hat nämlich ein DC-Offset zwischen den beiden Kollektoren des Differenzverstärkerpaares keinen Einfluß auf den Reglereingang und außerdem kann der Kollektor des nicht zur Auskopplung des Reglereingangssignales dienenden Differenzverstärker-Transistors unmittelbar mit dem Emitter eines zweiten Transistors, der in Basisschaltung betrieben wird, unter Bildung einer Kaskodeschaltung zusammengeschaltet werden.

Zur Verarbeitung eines unsymmetrischen Oszillatorsignales ist ein Regler der erfindungsgemäßen Art von Vorteil. Durch geeignete Wahl des Stromes der ersten Konstantstromquelle $I_4$ wird der neunte Transistor $T_9$ in dem Arbeitspunkt betrieben, in dem der Gleichrichterwirkungsgrad des Transistors optimal ist. Wird also z.B., wie bei Oszillatoren üblich, am Signaleingang ER des beschriebenen Reglers ein Signal eingespeist, das sich aus Wechselspannungskomponenten und einer Gleichspannungskompo nente zusammensetzt, so liegt dieses Signal unmittelbar am Basisanschluß des neunten Transistors $T_9$ an und am Emitter des neunten Transistors $T_9$ steht folglich eine Gleichspannung an, die sich aus den einweggleichgerichteten Komponenten aller Signalfrequenzen sowie dem Eingangssignal-Gleichspannungsanteil zusammensetzt. Am Basisanschluß des zehnten Transistors $T_{10}$ liegt nur der Teil des Eingangssignales an, dessen Frequenz kleiner als die Grenzfrequenz des Tiefpaßfilters F ist. Die Anteile höherer Frequenz werden abgedämpft. Deshalb sind auch in der Gleichspannung, die am Emitter des zehnten Transistors $T_{10}$ ansteht, keine Komponenten enthalten, die durch Gleichrichten von Signalen höherer Frequenzen herrühren. Das Signal am Emitter des neunten Transistors $T_9$ unterscheidet sich also von dem Signal am Emitter des zehnten Transistors $T_{10}$, abgesehen von einem Faktor nur um den gleichgerichteten Anteil des Reglereingangssignales, dessen Frequenz oberhalb der Grenzfrequenz des Tiefpasses F liegt. Die Gleichspannungskomponente des Eingangssignales sowie die Signalanteile, deren Frequenz unterhalb der Grenzfrequenz des Tiefpasses F liegt, werden in den Emitterausgangssignalen des neunten und des zehnten Transistors $T_9$, $T_{10}$ in gleicher Weise berücksichtigt. Wird das Emitterausgangssignal des neunten Transistors $T_9$ an dem nichtinvertierenden Eingang, das Emitterausgangssignal des zehnten Transistors $T_{10}$ an dem invertierenden Eingang eines Operationsverstärkers OP eingespeist, so liefert der Ausgang dieses Operationsverstärkers OP die mit einem Faktor gewichteten Eingangssignalanteile, deren Frequenz höher als die Grenzfrequenz des Tiefpaßfilters ist. Die Gleichspannungskomponente und die niederfrequenten Störanteile des Eingangssignales der Schaltung sind aufgrund der hohen Gleichtaktunterdrückung des Operationsverstärkers OP nicht in dessen Ausgangssignal enthalten. Der Faktor, mit dem die höherfrequenten Eingangssignalkomponenten gewichtet werden, kann durch Wahl des Verhältnisses des Stromes der ersten Konstantstromquelle $I_4$ zum Strom der zweiten Konstantstromquelle $I_5$ vorgegeben werden. Die Variation dieses Stromverhältnisses ermöglicht also eine Sollwerteinstellung, es wird keine weitere Gleichspannungsaddition an einem der Eingänge des Operationsverstärkers benötigt.

Außerdem legt das Verhältnis der Ströme der ersten Konstantstromquelle $I_4$ und der zweiten Konstantstromquelle $I_5$ zueinander den Regelsinn fest. Durch Vertauschen der Operationsverstärkereingänge wird der Regelsinn umgekehrt. Um den niederohmigen Reglereingang ER hochohmig an den ersten Oszillatorverstärkereingang $A_1$ anzukoppeln, ist ein Trennverstärker TA vorgesehen.

Minimale Signallaufzeiten im Hochfrequenzteil der Schaltung und eine dementsprechend größere Bandbreite lassen sich durch Einsparen von parasitären Kapazitäten im Bereich der Basisanschlüsse der Differenzverstärker-Transistoren erzielen. Um eine zusätzliche kapazitive Belastung der Basisanschlüsse durch die Reglerschaltung zu vermeiden, wirkt der Regler erfindungsgemäß nicht auf das Basispotential der Differenzverstärker-Transistoren, sondern beeinflußt die Ausgangsamplitude des Oszillators durch Steuerung des Differenzverstärkerstromes.

Wird das Eingangssignal des vorgesehenen Amplitudenregelkreises von einem unsymmetrischen Ausgangssignal des Oszillator-Differenzverstärkers abgeleitet, so wird das zusätzliche Rauschen der Regelschleife nicht, wie z.B. bei Schaltungen nach der DE-PS 30 41 392, im Differenzverstärkerpaar des Oszillator-Verstärkers kompensiert, sondern tritt als Störgröße an einem ersten Ausgang des Oszillator-Verstärkers auf.

Die Auswirkung des Rauschens der Regelschleife auf das Oszillator-Ausgangssignal läßt sich jedoch durch eine vierte Kapazität entsprechender Größe minimieren, die den Steuereingang der als Stellglied vorgesehenen spannungsgesteuerten Stromquelle mit dem Bezugspotential (Masse) verbindet.

Eine weitere Unterdrückung des von der Regelschleife herrührenden zusätzlichen Rauschleistungsanteiles des Oszillator-Ausgangssignales erreicht man dadurch, daß die als Stellglied dienende spannungsgesteuerte Stromquelle durch Transistorschaltungen mit starker Stromgegenkopplung realisiert ist, so daß der am Steuereingang dieser spannungsgesteuerten Stromquelle nicht unter drückte Restanteil des zusätzlichen Rauschens der Regelschleife mit einem möglichst kleinen Verstärkungsfaktor, der insbesondere kleiner als 1 ist, am Ausgang des Oszillator-Verstärkers ansteht. Ein entsprechend kleiner Verstärkungsfaktor kann dadurch erzielt werden, daß der resultierende Innenwiderstand der zweiten spannungsgesteuerten Stromquelle $I_2$ nicht kleiner ist als der am Kollektor des zweiten Transistors angeschlossene Lastwiderstand der Oszillator-Verstärkerschaltung.

Ein hoher Innenwiderstand der zwischen den Emittern des Oszillator-Differenzverstärkertransistorpaares und dem Bezugspotential angeordneten steuerbaren Stromquelle begrenzt jedoch die über den Transistoren maximal anstehende Spannung und steht somit der Minimierung der Transistor-Sperrschicht-Kapazität entgegen. Deshalb ist bezüglich der Minimierung des zusätzlichen Rauschens der Regelschleife eine übliche spannungsgesteuerte Stromquelle als Stellglied wenig geeignet.

Die Ausgangsamplitude der Oszillator-Differenzverstärkerschaltung kann in Abhängigkeit von der Reglerausgangsgröße dadurch variiert werden, daß die Emitteranschlüsse der Oszillator-Differenzverstärker-Transistoren über eine Stromquelle mit dem Stromeingang einer siebten Konstantstromquelle verbunden sind und der Stromausgang einer weiteren, spannungsgesteuerten Stromquelle ebenfalls an den Stromeingang dieser siebten Konstantstromquelle geschaltet ist und die Emitterströme, deren Summe sich aus der Differenz des Stromes der siebten Konstantstromquelle und des Stromes der spannungsgesteuerten Stromquelle ergibt, in Abhängigkeit vom Strom der spannungsgesteuerten Stromquelle, die als Stellglied dient und deren Steuereingang vom Reglerausgang angesteuert wird, variiert werden.

FIG 2 beschreibt eine besonders günstige Ausführungsform der Erfindung.

Ein Oszillator-Verstärker, bei dem die Anschluß-Pins des dritten Verstärkerausganges $A_2$ und des Hochpunktes des frequenzbe stimmenden Schaltungsteiles beliebig, auch nebeneinander angeordnet werden können, wobei das Auftreten störender Interferenzbildung zwischen Signalen dieser beiden Anschlüsse vermieden wird, wird erfindungsgemäß, wie in FIG 2 gezeigt, durch eine oben beschriebene Halbleiterschaltung realisiert, bei der außerdem die erste spannungsgesteuerte Stromquelle als Parallelschaltung einer zweiten spannungsgesteuerten Stromquelle $I_2$ und einer dritten spannungsgesteuerten Stromquelle $I_3$ ausgebildet ist und die Steuereingänge und die Stromausgänge dieser zweiten und dritten spannungsgesteuerten Stromquelle $I_2$, $I_3$ zusammengeschaltet sind, bei der der Stromeingang der dritten spannungsgesteuerten Stromquelle $I_3$ an das dritte Potential $U_3$ angeschlossen ist, der Stromeingang der zweiten spannungsgesteuerten Stromquelle $I_2$ mit dem an das zweite Potential $U_2$ angeschlossenen ersten Widerstand $R_1$ verbunden ist und der Strom der zweiten spannungsgesteuerten Stromquelle $I_2$ von gleicher Größe ist wie der Strom der dritten spannungsgesteuerten Stromquelle $I_3$, bei der ein viertes Potential, das insbesondere mit dem ersten Potential $U_1$ identisch sein kann, über einen dritten Widerstand $R_3$ an den Kollektoranschluß eines vierten Transistors $T_4$ und an den Basisanschluß eines fünften Transistors $T_5$ geschaltet ist, bei der der Basisanschluß des vierten Transistors $T_4$ insbesondere mit dem Basisanschluß des dritten Transistors $T_3$ zusammengeschaltet ist, der Kollektor des fünften Transistors $T_5$ an das vierte Potential angeschlossen ist, bei der der Emitteranschluß des fünften Transistors $T_5$ als zweiter Verstärkerausgang $A_2$ über eine Stromquelle, insbesondere einen Widerstand mit dem Bezugspotential (Masse) verbunden ist, und der Emitteranschluß des vierten Transistors $T_4$ zur Beaufschlagung des ersten Widerstandes $R_1$ und des Stromeinganges der zweiten spannungsgesteuerten Stromquelle $I_2$ mit dem zweiten Potential $U_2$ vorgesehen ist, wobei die Ausgangssignale des ersten und des zweiten Verstärkerausganges $A_1$, $A_2$ weitgehend phasengleich sind.

Werden, wie in FIG 2 angedeutet, in einer Schaltung mehrere Oszillatoren mit ihren entsprechenden Oszillator-Verstärkern, insbesondere zur Erweiterung der Bandbreite, derart vorgesehen, daß jeweils nur einer der Oszillatoren in Betrieb ist, so hat man bei Oszillator-Verstärker-Schaltungen, die gemäß dem oben dargelegten Erfindungsgegenstand aufgebaut sind, die Möglichkeit, die Arbeitspunkt-Gleichspannungsversorgung des zwei-

ten Transistors $T_2$, die erste Kapazität $C_1$, den zweiten Widerstand $R_2$, die erste spannungsgesteuerte Stromquelle, den vierten Transistor $T_4$, den fünften Transistor $T_5$ einschließlich seiner oben beschriebenen Beschaltung sowie die vierte Kapazität $C_4$ jeweils nur einmal vorzusehen.

FIG 2 zeigt eine Schaltungsanordnung mit zwei alternativ zu betreibenden Oszillatoren. Bei der Stromquelle $I_2$ und dem Transistor $T_4$ ist angedeutet, daß die Zahl der anschließbaren Oszillatoren auch größer sein kann. Die Schaltungselemente, die für jeden verwedeten Oszillator getrennt erforderlich sind und jeweils die gleiche Funktion erfüllen, sind mit gleichen Bezugszeichen versehen. Zur besseren Unterscheidbarkeit sind die Bezugszeichen der Elemente des zweiten Oszillators jeweils mit einem Strich gekennzeichnet.

In FIG 2 wird auch eine besonders günsstige Ausgestaltungsform der beschriebenen Reglerschaltung, gezeigt die sich von der Schaltung nach FIG 1 dadurch unterscheidet, daß der Emitteranschluß des neunten Transistors $T_9$ nicht unmittelbar mit dem einen Eingang des Operationsverstärkers OP, sondern unter Bildung einer Darlington-Stufe mit dem Basisanschluß eines elften Transistors $T_{11}$ verbunden ist, daß der Emitteranschluß dieses elften Transistors $T_{11}$ an den einen Eingang des Operationsverstärkers OP angeschlossen und über eine dritte Konstantstromquelle $I_6$ an das Bezugspotential geschaltet ist, daß der Emitteranschluß des zehnten Transistors $T_{10}$ nicht unmittelbar mit dem anderen Eingang des Operationsverstärkers OP, sondern unter Bildung einer Darlington-Stufe mit dem Basisanschluß eines zwölften Transistors $T_{12}$ verbunden ist, daß der Emitteranschluß dieses zwölften Transistors $T_{12}$ an den anderen Eingang des Operationsverstärkers OP angeschlossen und über eine vierte Konstantstromquelle $I_7$ an das Bezugspotential geschaltet ist, daß der Kollektor des elften Transistors $T_{11}$ und der Kollektor des zwölften Transistors $T_{12}$ jeweils an ein Potential, insbesondere das fünfte Versorgungspotential $U_4$ angeschlossen sind und daß insbesondere als invertierender Eingang des Operationsverstärkers OP der Basisanschluß eines dreizehnten Tansistors $T_{13}$ und als nichtinvertierender Eingang des Operationsverstärkers OP der Basisanschluß eines vierzehnten Transistors $T_{14}$ vom gleichen Typ vorgesehen ist, daß insbesondere der Kollektoranschluß des dreizehnten Transistors und der Kollektoranschluß des vierzehnten Transistors an ein Potential, insbesondere das fünfte Versorgungspotential $U_4$ angeschlossen sind, daß insbesondere der Emitter des dreizehnten Transistors $T_{13}$ mit dem Emitter eines fünfzehnten Transistors $T_{15}$ und der Emitter des vierzehnten Transistors $T_{14}$ mit dem Emitter eines sechzehnten Transistors $T_{16}$ verbunden ist, wobei der Typ des fünfzehnten und des sechzehnten Transistors $T_{15}$, $T_{16}$ komplementär zum Typ des dreizehnten und des vierzehnten Transistors $T_{13}$, $T_{14}$ ist, daß insbesondere die Basis des fünfzehnten Transistors $T_{15}$ und die Basis des sechzehnten Transistors $T_{16}$ an den Kollektor des fünfzehnten Transistors $T_{15}$ geschaltet sind, daß insbesondere die Kollektoren des fünfzehnten und des sechzehnten Transistors $T_{15}$, $T_{16}$ über je eine Konstantstromquelle an das Bezugspotential angeschlossen sind und der Kollektor des sechzehnten Transistors $T_{16}$ als Ausgang des Operationsverstärkers OP vorgesehen ist und daß insbesondere der Basisanschluß des zehnten Transistors $T_{10}$ über einen sechsten Widerstand $R_6$ mit dem Basisanschluß des neunten Transistors $T_9$ und über eine dritte Kapazität $C_3$ mit dem Bezugspotential verbunden ist. Der Reglereingang ist in FIG 2 durch einen in Kollektorschaltung eingesetzten siebzehnten Transistor $T_{17}$ vom ersten Verstärkerausgang $A_1$ dergestalt entkoppelt, daß die Basis des siebzehnten Transistors $T_{17}$ mit dem ersten Oszillatorverstärker-Ausgang $A_1$ verbunden ist, daß der Kollektor des siebzehnten Transistors $T_{17}$ an ein Versorgungspotential angeschlossen ist und daß der Emitter des siebzehnten Transistors $T_{17}$ über einen siebten Widerstand $R_7$ gegen das Bezugspotential Masse geschaltet ist und unmittelbar mit dem Reglereingang ER verbunden ist.

In Oszillator-Schaltungen, insbesondere für die Anwendung als Mischer-Oszillator, ist am Oszillatorverstärker neben dem Ausgang zum Amplitudenregler und dem typischerweise ein symmetrisches Signal führenden Ausgang zum Mischer oft noch ein weiterer, dritter Signalausgang erforderlich, der zum Anschluß an periphere Schaltungsgruppen, insbesondere an einen Zähler vorgesehen ist. Um Interferenzen zwischen dem Signal an diesem dritten Signalausgang $A_2$ und dem Signal, das am Hochpunkt des frequenzbestimmenden Schaltungsteiles ST ansteht, zu vermeiden, müssen die entsprechenden Anschluß-Pins der integrierten Schaltung einen möglichst großen Abstand voneinander haben, mindestens jedoch muß zwischen den Anschluß-Pins ein fest definiertes Bezugspotential vorgegeben werden. Diese Maßnahmen sind nur dann nicht erforderlich, wenn sichergestellt ist, daß das Ausgangssignal am dritten Signalausgang $A_2$ mit dem Signal am Hochpunkt des frequenzbestimmenden Schaltungsteiles ST zu jedem Zeitpunkt weitgehend in Phase ist. Phasengleichheit zwischen dem Anschluß des frequenzbestimmenden Schaltungsteiles ST und dem dritten Signalausgang erreicht man dadurch, daß bei allen Elementen der Auskoppelschaltung zwischen dem Anschluß des frequenzbestimmenden Schaltungsteils ST und dem dritten Ausgang das jeweilige Ausgangssignal zum jeweiligen Eingangssignal in Phase ist.

Als solche Elemente sind ohm'sche Widerstände sowie Transistoren in Basis- oder Kollektorschaltung bekannt, wobei in den Transistoren im Mittel ein konstanter Strom fließen sollte.

In FIG 2 setzt sich der Kollektorstrom des vierten Transistors $T_4$ im wesentlichen aus dem Kollektorstrom des zweiten Transistors $T_2$ und dem Strom der zweiten spannungsgesteuerten Stromquelle $I_2$ zusammen. Der konstante Strom durch den zweiten Widerstand $R_2$ setzt sich aus der Summe der Oszillator-Verstärkerströme, dem Strom der zweiten und dem Strom der dritten spannungsgesteuerten Stromquelle $I_2$, $I_3$ zusammen. Unter der Voraussetzung, daß die Ströme in den beiden Zweigen des Oszillator-Differenz-Verstärkers $T_1$, $T_2$ sowie die Ströme in der zweiten und der dritten spannungsgesteuerten Stromquelle $I_2$, $I_3$ jeweils nahezu gleich groß sind, ändern sich zwar bei Variation der Steuerspannung an den Steuereingängen der als Stellglied dienenden spannungsgesteuerten Stromquellen $I_2$, $I_3$ die Ströme des ersten und zweiten Transistors $T_1$, $T_2$, der Strom im vierten Transistor $T_4$ bleibt jedoch nahezu konstant. Da der vierte Transistor $T_4$ in Basisschaltung und der fünfte Transistor $T_5$ in Kollektorschaltung eingesetzt sind, tritt zwischen ihrem Eingang und ihrem Ausgang jeweils keine nennenswerte Phasenverschiebung auf.

Bei monolithisch zu integrierenden Halbleiterschaltungen sollte die Chip-Fläche und die Zahl der nach außen führenden Anschlüsse minimiert werden. Werden mehrere ähnliche Baugruppen auf einem Chip vereint und zusammengeschaltet, so ist es folglich von Vorteil, solche Schaltungselemente, die in jeder Baugruppe erforderlich sind, nur einmal vorzusehen und allen Baugruppen gemeinsam zugehörig zu beschalten. Von besonderem Vorteil ist in diesem Fall das Einsparen von internen Kapazitäten, da diese eine relativ große Chip-Fläche benötigen und das Einsparen von externen Schaltungsmitteln, da diese jeweils einer eigenen Kontaktierung nach außen bedürfen.

Bei Reglerschaltungen nach FIG 1 unterscheiden sich die Potentiale an den Operationsverstärkereingängen von dem Potential am Signaleingang der Regelschaltung gleichspannungsmäßig nur um die Spannung, die über einer Basis-Emitter-Strecke ansteht. Aufgrund dieser geringen Potentialdifferenz ist der Stellbereich des Reglers, der durch das Verhältnis des Stromes des neunten Transistors $T_9$ zum Strom des zehnten Transistors $T_{10}$ beeinflußt wird, begrenzt, denn aufgrund der logarithmischen Abhängigkeit des Stromes von der Spannung führt eine geringe Erhöhung der Spannungsdifferenz zu einer relativ großen Erhöhung der Stromdifferenz, eine zu hohe Stromdifferenz steht jedoch einer exakten Einstellbarkeit der Schaltung entgegen. Durch die beschriebene Hintereinanderschaltung des neunten und des elften Transistors $T_9$, $T_{11}$ bzw. des zehnten und des zwölften Transistors $T_{10}$, $T_{12}$ liegen jeweils zwei Basis-Emitter- Strecken zwischen dem Signaleingang des Reglers und den Operationsverstärkereingängen. Um die gleiche Spannungsdifferenz zu erzielen ist dadurch zwischen den Strömen der Darlington-Stufen $T_9$, $T_{11}$ und $T_{10}$, $T_{12}$ in Schaltungen nach FIG 2 eine erheblich geringere Stromdifferenz erforderlich, als zwischen den Strömen des neunten Transistors $T_9$ und des zehnten Transistors $T_{10}$ in Schaltungen nach FIG 1. In Schaltungen nach FIG 2 wird der Sollwert nicht nur durch das Verhältnis des Stromes der ersten Konstantstromquelle $I_4$ zu dem Strom der zweiten Konstantstromquelle $I_5$ bestimmt, sondern auch durch das Verhältnis des Verhältnisses des Stromes der dritten Konstantstromquelle $I_6$ zum Strom der ersten Konstantstromquelle $I_4$ zu dem Verhältnis des Stromes der vierten Kontantstromquelle $I_7$ zu dem Strom der zweiten Konstantstromquelle $I_5$. Alle Konstantstromquellen der Reglerschaltung können insbesondere, wie in FIG 2 gezeigt, jeweils als Transistor in Basisschaltung, dessen Emitter über einen Widerstand an das Bezugspotential geschaltet ist, dessen Basis mit einem konstanten Potential beaufschlagt wird und dessen Kollektor als Stromeingang vorgesehen ist, aufgebaut werden. Bei konstantem Basispotential wird hierbei der Strom der Stromquelle durch den Widerstand festgelegt. Sind alle Stromquellen auf diese Weise realisiert und liegen die Basisanschlüsse aller Stromquellentransistoren auf dem gleichen Referenzpotential, so kann im Bedarfsfall durch Beeinflussung des Referenzpotentiales die gesamte Schaltung stromlos geschaltet werden.

Die erste spannungsgesteuerte Stromquelle kann, wie in FIG 2 gezeigt, insbesondere durch eine Halbleiterschaltung realisiert werden, bei der die dritte spannungsgesteuerte Stromquelle $I_3$ von einem sechsten Transistor $T_6$ gebildet wird, dessen Emitteranschluß über einen vierten Widerstand $R_4$ mit dem Stromausgang der dritten spannungsgesteuerten Stromquelle $I_3$ verbunden ist, bei der als zweite spannungsgesteuerte Stromquelle $I_2$ mindestens ein siebter Transistor $T_7$ und bei Schaltungen nach Anspruch 4 für jeden zusätzlichen Oszillator ein weiterer Transistor vorgesehen ist, wobei der Emitteranschluß des siebten Transistors $T_7$ über einen fünften Widerstand $R_5$ und die Emitteranschlüsse der weiteren die zweite spannungsgesteuerte Stromquelle bildenden Transistoren über je einen weiteren Widerstand mit dem Stromausgang der zweiten und der dritten spannungsgesteuerten Stromquelle $I_2$, $I_3$ verbunden sind, bei der die Basisanschlüsse der die zweite und die dritte spannungsgesteuerte Stromquelle $I_2$, $I_3$ bildenden Transistoren $T_6$, $T_7$... unmittelbar mit den

Steuereingängen der zweiten und der dritten spannungsgesteuerten Stromquelle $I_2$, $I_3$ verbunden sind, bei der der Kollektoranschluß des sechsten Transistors $T_6$ als Stromeingang der dritten spannungsgesteuerten Stromquelle $I_3$ an das dritte Potential $U_3$ geschaltet ist, bei der die Kollektoranschlüsse der die zweite spannungsgesteuerte Stromquelle $I_2$ bildenden Transistoren $T_7$, ... als Stromeingang der zweiten spannungsgesteuerten Stromquelle $I_2$ jeweils an den Emitteranschluß des vierten Transistors $T_4$ geschaltet sind, wobei der vierte Transistor insbesondere für jeden Kollektoranschluß der zweiten spannungsgesteuerten Stromquelle $I_2$ einen eigenen Emitter vorgesehen hat, bei der der Strom der zweiten und der Strom der dritten spannungsgesteuerten Stromquelle $I_2$, $I_3$ jeweils von gleicher Größe sind und wobei sowohl der vierte Widerstand $R_4$, als auch der aus der Parallelschaltung des fünften Widerstandes $R_5$ mit den evtl. weiteren, in der zweiten spannungsgesteuerten Stromquelle $I_2$ enthaltenen Widerständen resultierende Widerstandswert, jeweils größer als der erste Widerstand $R_1$ ist.

Der Operationsversträrker ist in FIG 2 durch eine raumsparend aufbaubare Differenzverstärkerschaltung mit Stromspiegel und einer fünften und einer sechsten Konstantstromquelle realisiert.

Als Tiefpaß F reicht in manchen Fällen, wenn die Grenzfrequenz des Tiefpasses genügend klein zur Signalfrequenz der Regelgröße gewählt werden kann, ein Filter erster Ordnung aus, das zwischen seinem Eingang und seinem Ausgang einen Widerstand vorgesehen hat und dessen Ausgang über eine Kapazität an das Bezugspotential angeschlossen ist.

Die Schaltung der einzelnen Stromquellen ist jedoch beliebig wählbar. Als Transistoren können bei entsprechender Beschaltung sowohl bipolare NPN- oder PNP-Transistoren, als auch Feldeffekttransistoren eingesetzt werden.

**Ansprüche**

1. Monolithisch integrierbare, amplitudenregelbare Oszillator-Verstärker-Schaltung, die von einem aus einem ersten Transistor ($T_1$) und aus einem mit diesem emittergekoppelten zweiten Transistor ($T_2$) bestehenden Differenzverstärker gebildet ist, bei der der Basisanschluß des ersten Transistors ($T_1$) an ein frequenzbestimmendes Schaltungsteil (ST) geschaltet ist, die Basis des ersten Transistors ($T_1$) und die Basis des zweiten Transistors ($T_2$) mit einer Gleichspannung beaufschlagt sind, der Basisanschluß des zweiten Transistors ($T_2$) über eine erste Kapazität ($C_1$) an das Bezugspotential (Masse) angeschlossen ist und das frequenzbestimmende Schaltungsteil (ST) an den Kollektor

des zweiten Transistors ($T_2$) geschaltet ist, wobei das frequenzbestimmende Schaltungsteil (ST) insbesondere unter Vermittlung von Kapazitäten an den Oszillator-Verstärker angeschlossen ist, bei der der Kollektoranschluß des ersten Transistors ($T_1$) über einen Schaltungsteil an ein erstes Potential ($U_1$) angeschlossen ist, der Kollektor des zweiten Transistors ($T_2$) über einen Schaltungsteil an ein zweites Potential ($U_2$) geschaltet ist und die Emitter des ersten Transistors ($T_1$) und des zweiten Transistors ($T_2$) über eine erste Stromquelle, insbesondere einem Widerstand, mit dem Bezugspotential (Masse) verbunden sind, bei der ein Regler mit einer Istwerterfassung durch Gleichrichten, einer Eingangssignal-Mittelwertunterdrückung durch Verwendung einer Differenzverstärkeranordnung sowie einer Sollwert-Einstellung vorgesehen ist,
**dadurch gekennzeichnet,**
daß der Kollektor des ersten Transistors ($T_1$) unter Bildung einer Kaskodeschaltung unmittelbar mit dem Emitter eines dritten Transistors ($T_3$) verbunden ist, der Kollektor dieses dritten Transistors ($T_3$) an das erste Potential ($U_1$) geschaltet ist und die Basis des dritten Transistors ($T_3$) in bekannter Weise mit einer Gleichspannung beaufschlagt ist, daß der Kollektor des zweiten Transistors ($T_2$) als ein erster Verstärkerausgang ($A_1$) vorgesehen ist und über einen ersten Widerstand ($R_1$) an das zweite Potential ($U_2$) geschaltet ist, daß als erste Stromquelle die Serienschaltung einer zweiten Stromquelle ($I_1$) und einer mit dieser über einen ersten Schaltungsknoten ($K_1$) verbundenen siebten Konstantstromquelle, insbesondere eines zweiten Widerstandes ($R_2$), vorgesehen ist, daß für den Oszillatorverstärker eine Amplitudenregelung in Abhängigkeit vom Ausgangssignal vorgesehen ist, daß der Basisanschluß eines neunten Transistors ($T_9$) mit einem Signaleingang (ER) der Reglerschaltung verbunden ist und der Basisanschluß eines zehnten Transistors ($T_{10}$) über einen Tiefpaß (F) ebenfalls an den Signaleingang (ER) geschaltet ist, daß die Kollektoranschlüsse des neunten und des zehnten Transistors $T_9$, $T_{10}$ jeweils an ein Potential angeschlossen sind, daß der Emitter des neunten Transistors mit einem Eingang eines Operationsverstärkers (OP) verbunden ist und über eine zweite Kapazität ($C_2$) sowie über eine erste Konstantstromquelle ($I_4$) an das Bezugspotential (Masse) geschaltet ist, daß der Emitter des zehnten Transistors ($T_{10}$) mit dem anderen Eingang des Operationsverstärkers (OP) verbunden ist und außerdem über eine zweite Konstantstromquelle ($I_5$) an das Bezugspotential (Masse) geschaltet ist, daß der Ausgang des Operationsverstärkers (OP) mit dem Ausgang (AR) des Reglers verbunden ist, daß das Verhältnis des Stromes der zweiten Konstantstromquelle ($I_5$) zu dem Strom der ersten Konstantstromquelle ($I_4$) zur Sollwerteinstellung vorgesehen ist, daß das Stellglied des Regelkreises aus einer ersten spannungsgesteuerten Stromquelle besteht, daß der Steuerspannungseingang dieser ersten spannungsgesteuerten Stromquelle mit einer von einem Regler (Reg) bereitgestellten Stellgröße beaufschlagt wird und daß der Stromeingang der ersten spannungsgesteuerten Stromquelle an ein drittes Potential ($U_3$) angeschlossen ist und ihr Stromausgang mit dem ersten Schaltungsknoten ($K_1$) verbunden ist (FIG 1).

2. Halbleiterschaltung nach Anspruch 1,
**dadurch gekennzeichnet,**
daß die zweite Stromquelle ($I_1$) durch einen achten Transistor ($T_8$) realisiert ist, daß der Kollektoranschluß des achten Transistors ($T_8$) mit den Emitteranschlüssen des ersten und des zweiten Transistors ($T_1$, $T_2$) zusammengeschaltet ist, daß der Emitter des achten Transistors ($T_8$) mit dem ersten Knoten ($K_1$) verbunden ist und daß die Basis des achten Transistors mit einem ersten Referenzpotential beaufschlagt wird.

3. Halbleiterschaltung nach Anspruch 1 oder 2,
**dadurch gekennzeichnet,**
daß die erste spannungsgesteuerte Stromquelle als Parallelschaltung einer zweiten spannungsgesteuerten Stromquelle ($I_2$) und einer dritten spannungsgesteuerten Stromquelle ($I_3$) besteht, wobei die Steuereingänge und die Stromausgänge dieser zweiten und dritten spannungsgesteuerten Stromquelle ($I_2$, $I_3$) zusammengeschaltet sind, daß der Stromeingang der dritten spannungsgesteuerten Stromquelle ($I_3$) an das dritte Potential ($U_3$) angeschlossen ist, daß der Stromeingang der zweiten spannungsgesteuerten Stromquelle mit dem an das zweite Potential ($U_2$) angeschlossenen ersten Widerstand ($R_1$) verbunden ist und der Strom der zweiten spannungsgesteuerten Stromquelle ($I_2$) von gleicher Größe ist wie der Strom der dritten spannungsgesteuerten Stromquelle ($I_3$), daß ein viertes Potential, das insbesondere mit dem ersten Potential ($U_1$) identisch sein kann, über einen dritten Widerstand ($R_3$) an den Kollektoranschluß eines vierten Transistors ($T_4$) und an den Basisanschluß eines fünften Transistors ($T_5$) geschaltet ist, daß der Basisanschluß des vierten Transistors ($T_4$) insbesondere mit dem Basisanschluß des dritten Transistors ($T_3$) zusammengeschaltet ist, daß der Kollektor des fünften Transistors ($T_5$) an das vierte Potential angeschlossen ist, daß der Emitteranschluß des fünften Transistors ($T_5$) als zweiter Verstärkerausgang ($A_2$) über eine Stromquelle, insbesondere einen Widerstand mit dem Bezugspotential (Masse) verbunden ist und daß der Emitteranschluß des vierten Transistors ($T_4$) zur Beaufschlagung des ersten Widerstandes ($R_1$) und des Stromeinganges der zweiten spannungsgesteuerten Stromquelle ($I_2$) mit dem zweiten Potential ($U_2$)

vorgesehen ist, wobei die Ausgangssignale des ersten und des zweiten Verstärkerausganges ($A_1$, $A_2$) weitgehend phasengleich sind.

4. Halbleiterschaltung nach Anspruch 1, 2 oder 3,
**dadurch gekennzeichnet,**
daß der Steuereingang der ersten spannungsgesteuerten Stromquelle unter Vermittlung einer vierten Kapazität ($C_4$) gegen das Bezugspotential (Masse) geschaltet ist.

5. Halbleiterschaltung, bestehend aus mehreren Oszillator-Verstärkern nach Anspruch 2, 3 oder 4,
**dadurch gekennzeichnet,**
daß die Arbeitspunkt-Gleichstromversorgung des zweiten Transistors ($T_2$), die erste Kapazität ($C_1$), der zweite Widerstand ($R_2$), die erste spannungsgesteuerte Stromquelle ($I_1$), die vierte Kapazität ($C_4$), der vierte Transistor ($T_4$) und der fünfte Transistor ($T_5$) einschließlich seiner in Anspruch 3 beschriebenen Beschaltung nur einmal vorgesehen sind und allen Oszillator-Verstärker-Schaltungen gemeinsam sind.

6. Halbleiterschaltung nach einem der Ansprüche 2, 3, 4 oder 5,
**dadurch gekennzeichnet,**
daß die dritte spannungsgesteuerte Stromquelle ($I_3$) von einem sechsten Transistor ($T_6$) gebildet wird, dessen Emitteranschluß über einen vierten Widerstand ($R_4$) mit dem Stromausgang der dritten spannungsgesteuerten Stromquelle ($I_3$) verbunden ist, daß als zweite spannungsgesteuerte Stromquelle ($I_2$) mindestens ein siebter Transistor ($T_7$) und bei Schaltungen nach Anspruch 4 für jeden zusätzlichen Oszillator ein weiterer Transistor vorgesehen ist, wobei der Emitteranschluß des siebten Transistors ($T_7$) über einen fünften Widerstand ($R_5$) und die Emitteranschlüsse der weiteren die zweite spannungsgesteuerte Stromquelle bildenden Transistoren über je einen weiteren Widerstand mit dem Stromausgang der zweiten und der dritten spannungsgesteuerten Stromquelle ($I_2$, $I_3$) verbunden sind, daß die Basisanschlüsse der die zweite und die dritte spannungsgesteuerte Stromquelle ($I_2$, $I_3$) bildenden Transistoren ($T_6$, $T_7$...) unmittelbar mit den Steuereingängen der zweiten und der dritten spannungsgesteuerten Stromquelle ($I_2$, $I_3$) verbunden sind, daß der Kollektoranschluß des sechsten Transistors ($T_6$) als Stromein gang der dritten spannungsgesteuerten Stromquelle ($I_3$) an das dritte Potential ($U_3$) geschaltet ist und daß die Kollektoranschlüsse der die zweite spannungsgesteuerte Stromquelle ($I_2$) bildenden Transistoren ($T_7$, ...) als Stromeingang der zweiten spannungsgesteuerten Stromquelle ($I_2$) jeweils an das zweite Potential, insbesondere an den Emitteranschluß des vierten Transistors ($T_4$) geschaltet sind, wobei der vierte Transistor insbesondere für jeden Kollektoranschluß der zweiten spannungsgesteuerten Stromquelle ($I_2$) einen eigenen Emitter vorgesehen hat.

7. Halbleiterschaltung nach einem der vorhergehenden Ansprüche,
**dadurch gekennzeichnet,**
daß der Strom der zweiten und der Strom der dritten spannungsgesteuerten Stromquelle ($I_2$, $I_3$) jeweils von gleicher Größe sind.

8. Halbleiterschaltung nach Anspruch 6 oder 7,
**dadurch gekennzeichnet,**
daß sowohl der vierte Widerstand ($R_4$), als auch der aus der Parallelschaltung des fünften Widerstandes ($R_5$) mit den evtl. weiteren, in der zweiten spannungsgesteuerten Stromquelle ($I_2$) enthaltenen Widerständen resultierende Widerstandswert, jeweils größer als der erste Widerstand ($R_1$) ist.

9. Schaltung nach Anspruch 1,
**dadurch gekennzeichnet,**
daß der Emitteranschluß des neunten Transistors ($T_9$) nicht unmittelbar mit dem einen Eingang des Operationsverstärkers (OP), sondern unter Bildung einer Darlington-Stufe mit dem Basisanschluß eines elften Transistors ($T_{11}$) verbunden ist, daß der Emitteranschluß dieses elften Transistors ($T_{11}$) an den einen Eingang des Operationsverstärkers (OP) angeschlossen und über eine dritte Konstantstromquelle ($I_6$) an das Bezugspotential Masse geschaltet ist, daß der Emitteranschluß des zehnten Transistors ($T_{10}$) nicht unmittelbar mit dem anderen Eingang des Operationsverstärkers, sondern unter Bildung einer Darlington-Stufe mit dem Basisanschluß eines zwölften Transistors ($T_{12}$) verbunden ist, daß der Emitteranschluß dieses zwölften Transistors ($T_{12}$) an den anderen Eingang des Operationsverstärkers (OP) angeschlossen und über eine vierte Konstantstromquelle ($I_7$) an das Bezugspotential geschaltet ist, daß der Kollektor des elften Transistors ($T_{11}$) und der Kollektor des zwölften Transistors ($T_{12}$) jeweils an ein Potential, angeschlossen sind und zusätzlich zu dem Verhältnis der Ströme der ersten Konstantstromquelle ($I_4$) zu dem Strom der zweiten Konstantquelle ($I_5$) auch das Verhältnis des Verhältnisses des Stromes der dritten Konstantstromquelle ($I_6$) zu dem Strom der ersten Konstantstromquelle ($I_4$) zu dem Verhältnis des Stromes der vierten Konstantstromquelle ($I_7$) zu dem Strom der zweiten Konstantstromquelle ($I_5$) zur Sollwerteinstellung vorgesehen sind.

10. Schaltung nach Anspruch 1 oder 2,
**dadurch gekennzeichnet,**
daß die Kollektoranschlüsse des neunten und des zehnten Transistors ($T_9$, $T_{10}$) an ein gemeinsames fünftes Versorgungspotential ($U_4$) angeschlossen sind.

11. Schaltung nach Anspruch 1, 2 oder 3,
**dadurch gekennzeichnet,**
daß der Emitter des neunten Transistors ($T_9$) mit

dem nichtinvertierenden Eingang eines Operationsverstärkers (OP) verbunden ist und daß der Emitter des zehnten Transistors ($T_{10}$) mit dem invertierenden Eingang des Operationsverstärkers (OP) verbunden ist.

12. Schaltung nach Anspruch 1, 2, 3 oder 4,
**dadurch gekennzeichnet,**
daß als invertierender Eingang des Operationsverstärkers (OP) der Basisanschluß eines dreizehnten Tansistors ($T_{13}$) und als nicht invertierender Eingang des Operationsverstärkers (OP) der Basisanschluß eines vierzehnten Transistors ($T_{14}$) vom gleichen Typ vorgesehen ist, daß der Kollektoranschluß des dreizehnten Transistors ($T_{13}$) und der Kollektoranschluß des vierzehnten Transistors ($T_{14}$) an ein Potential, insbesondere das fünfte Versorgungspotential ($U_4$) angeschlossen sind, daß der Emitter des dreizehnten Transistors ($T_{13}$) mit dem Emitter eines fünfzehnten Transistors ($T_{15}$) und der Emitter des vierzehnten Transistors ($T_{14}$) mit dem Emitter eines sechzehnten Transistors ($T_{16}$) verbunden ist, wobei der Typ des fünfzehnten und des sechzehnten Transistors ($T_{15}$, $T_{16}$) komplementär zum Typ des dreizehnten und des vierzehnten Transistors ($T_{13}$, $T_{14}$) ist, daß die Basis des fünfzehnten Transistors ($T_{15}$) und die Basis des sechzehnten Transistors ($T_{16}$) an den Kollektor des fünfzehnten Transistors ($T_{15}$) geschaltet sind, daß die Kollektoren des fünfzehnten und des sechzehnten Transistors ($T_{15}$, $T_{16}$) über je eine Konstantstromquelle an das Bezugspotential angeschlossen sind und der Kollektor des sechzehnten Transistors ($T_{16}$) als Ausgang des Operationsverstärkers vorgesehen ist.

13. Schaltung nach einem der vorgenannten Ansprüche,
**dadurch gekennzeichnet,**
daß der Basisanschluß des zehnten Transistors ($T_{10}$) über einen sechsten Widerstand ($R_6$) mit dem Basisanschluß des neunten Transistors ($T_9$) und über eine dritte Kapazität ($C_3$) mit dem Bezugspotential (Masse) verbunden ist.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 588 968 (D.T. WILE) <br> * Spalte 1, Zeile 51 - Spalte 4, Zeile 41; Figuren 1,2 * <br> --- | 1 | H 03 L 5/00 |
| A | DE-A-2 803 430 (SIEMENS) <br> * Zusammenfassung; Figur * <br> --- | 1 | |
| A,D | EP-A-0 051 179 (SIEMENS) <br> * Zusammenfassung; Figur 1 * <br> --- | 1 | |
| A | PATENT ABSTRACTS OF JAPAN, Band 10, Nr. 309, 21. Oktober 1986, Seite 27 E 447; & JP-A-61 121 504 (MATSUSHITA ELECTRIC IND. CO. LTD) 09-06-1986 <br> --- | 1 | |
| A,D | U. TIETZE et al.: "Halbleiter-Schaltungstechnik", Auflage 5, 1980, Seiten 328-333, Springer Verlag, Berlin, DE <br> * Seite 329, Zeile 18 - Seite 333, Zeile 16; Figuren 14.4, 14,6 * <br> ----- | 1 | **RECHERCHIERTE SACHGEBIETE (Int. Cl.4)** <br><br> H 03 L <br> H 03 G |

Der vorliegende Recherchenbericht wurde für alle Patentansprüche erstellt

| Recherchenort | Abschlußdatum der Recherche | Prüfer |
|---|---|---|
| DEN HAAG | 17-10-1988 | DHONDT I.E.E. |